# EUROPEAN PATENT SPECIFICATION

(11) **EP 2 948 819 B1**
(45) Date of publication and mention of the grant of the patent: **01.03.2017**
(21) Application number: 13815809.2
(22) Date of filing: 20.12.2013
(51) Int. Cl.: G03F 7/30

(54) **PROCESSING WASTE WASHOUT LIQUID**
AUFBEREITUNG VON FLÜSSIGEN WASCHABFÄLLEN
LIQUIDE DE LAVAGE DE DÉCHETS DE TRAITEMENT

(30) Priority: 22.01.2013 GB 201301102
(43) Date of publication of application: 02.12.2015
(73) Proprietor: DANTEX GRAPHICS LTD., Bradford, West Yorkshire BD2 1EY (GB)
(72) Inventor: DANON, Richard, Leeds, Yorkshire LS17 8SG (GB)
(74) Representative: Oxley, Rachel Louise
(86) International application number: PCT/GB2013/053376
(87) International publication number: WO 2014/114900

(56) References cited:
- EP-A1- 0 642 058
- EP-A1- 0 813 116
- WO-A1-02/26472
- DE-C1- 4 442 712
- US-B1- 6 224 273

## Description

The present invention relates to apparatus and methods for processing waste washout liquid, in particular waste washout liquid containing photopolymer debris from photopolymer printing plate manufacture e.g. photopolymer relief flexographic printing plate manufacture.

### BACKGROUND

Photopolymer relief printing plates, such as flexographic printing plates, are manufactured using a blend of photopolymeric chemicals with rubber-like properties. They are extensively used in the printing industry for applications such as flexible packaging, envelope printing, paper and plastic sack printing, carton printing, and label printing.

Methods of producing the plates are well-known and are generally produced in the following manner using a system commonly referred to as a plate processor system. Initially a negative film depicting the required image is placed securely on to the face side of the photopolymer plate. The face side of the plate is then subjected to ultra violet light having a wave-length of between 250 and 500 nm. Light entering through the 'white' areas of the film hardens the polymer in these areas immediately, whilst the 'black' areas of the film reject the light, leaving the polymer surface under it to remain soft.

Methods of washing-out of photopolymer plates at a washout station within a plate processor system using a washout liquid such an organic solvent or water to remove the unhardened areas are also well-known.

For example, WO92/22015 and WO92/22014 describe a method of washing-out a pre-exposed printing plate using a continuous flow of fresh, clean, heated washout liquid. The washout liquid is supplied to the surface of the plate through a spray bar forming part of a washout brush which brushes the surface of the plate. The method involves cleaning and/or filtering the used washout liquid prior to re-use in the plate processor system in a subsequent washing-out (or disposal to waste).

WO93/07539 discloses a centrifugal filter unit for processing waste washout liquid. The unit has a removable collector (e.g. a liner or filter bag) upon which the photopolymer particles are deposited. Similar bag filter units are currently used in plate processor systems which rely on gravitational filtration rather than any centrifugal force.

WO2007/093797 discloses a filter unit having three stainless steel sieves with pore sizes of 200 micrometers, 100 micrometers and 70 micrometers each housed in a respective cartridge or canister. The washout liquid passes through the sieves from largest to smallest pore size. The smallest pore size sieve is housed in a charcoal filter cartridge. An increase in pressure of the washout liquid resulting from clogging of a sieve is detected and the operator is required to change the clogged/saturated cartridge. Similar canister filtration systems having textile filter candles of one or more effective pore sizes (ranging from 70 micrometers to 5 micrometers) and including a charcoal filter are currently used in plate processor systems for processing photopolymer plates.

The problem with the known centrifugal, bag and canister filter units is that the size of the bag/liner and candles is limited and clogging occurs after a relatively short period of time. In the case of the known canister filtration systems, the first filter candle tends to become clogged very quickly due to the presence of the larger debris particles in the waste water that encounters the first filter candle.

Replacement of the bag/liner and candles is a messy process which often causes water to drip onto the floor and units surrounding the filter unit. This causes a potential hazard to the user and requires time and effort to dry the floor/units.

A preferred aim of the present invention is to provide an improved filter unit which allows for substantially continuous processing of waste washout liquid from a plate processor system without requiring user intervention to replace clogged filter material.

### SUMMARY OF THE INVENTION

In a first aspect, the present invention provides a filter unit for filtering waste washout liquid from a plate processor system, said unit comprising:
a filtration chamber for receiving waste washout liquid,
a perforated conveyor for supporting a filter material at the base of the filtration chamber and for conveying filter material to and away from the base of the filtration chamber;
an activation unit for activating said conveyor when waste washout liquid reaches a predetermined height within said filtration chamber; and
a storage tank for storing filtered washout liquid after it has passed through said filter material and perforated base.

In the filter unit according to the first aspect of the present invention, when filter material supported on the perforated conveyor at the base of the filtration chamber becomes clogged by polymer debris such that the passage of waste washout liquid through the filter material is impeded, the level of waste washout liquid rises within the filtration chamber. When the level of waste washout liquid reaches a predetermined level within the filtration chamber, the activation unit triggers the conveyor to move the clogged filter material away from the base of the filtration chamber and to move clean filter material to the base of the filtration chamber. By providing a conveyor which is activated by an activation unit when the filter material becomes clogged with polymer debris, it is possible to remove the clogged filter material and replace it with fresh, clean, unused filter material without any user interaction and without any messy filter replacement step. This allows substantially continuous processing of the waste washout liquid and avoids the hazards and inconvenience associated with replacement of filter bags/liners/cartridges. Filtered washout liquid can be recycled from the storage tank back to a washout station within the plate processor system.

In preferred embodiments of the present invention, the storage tank is positioned directly below the perforated conveyor forming the base of the filtration chamber. In this way, filtered washout liquid can simply drip into the storage tank under gravitational pull. Alternatively, the filter unit may further comprise a pump e.g. a vacuum pump for driving the washout liquid through the filter material/perforated conveyor into the storage tank.

Preferably, the storage tank comprises heating means for heating the filtered washout liquid (e.g. to between 15 to 60°C) prior to its recycling back to the washout station of the plate processor system. Preferably, the heating means comprises at least one heat pad and/or at least one heating element. The at least one heat pad may be a ceramic- or silicone-based heat pad. The at least one heat pad may be affixed to a wall of the storage tank e.g. to an outer wall of the storage tank. The at least one heating element may be an immersion heater for immersion into the filtered washout liquid within the storage tank. By heating the filtered washout liquid prior to its recycling back to the washout station of the plate processor, it is possible to carry out the washout step using heated washout liquid which significantly improves the effectiveness of the washout step.

Preferably, the storage tank is formed of plastics material (e.g. polyvinylchloride, polycarbonate, polypropylene and/ or polybutylene terephthalate) or metal (e.g. aluminium or stainless steel). Most preferably, the storage tank is formed of stainless steel as this is an excellent conductor of heat (and therefore is ideal for use with at least one heating pad (and preferably a plurality of heating pads) on a wall of the storage tank). Furthermore, since stainless steel is rust-proof, it has a long service life.

In preferred embodiments, the filter unit further comprises a surfactant dispenser and/or a water-softener dispenser for dispensing surfactant/softener into the filtered washout liquid within the storage tank. The or each dispenser may include a pump e.g. a peristaltic pump to dispense a measured quantity of surfactant/softener into the filtered washout liquid at measured intervals. By providing a surfactant/softener dispenser to add surfactant/softener to the filtered washout liquid prior to its recycling back to the washout station of the plate processor, it is possible to carry out the washout step using soapy/softened washout liquid which significantly improves the effectiveness of the washout step. Furthermore, the softener/surfactant helps prevent the polymer debris from coagulating which helps reduce clogging of the filter material.

The storage tank preferably has a capacity of greater than 100 litres, e.g. 130 litres. This allows it to hold a quantity of filtered washout liquid sufficient for a substantially continuous supply of washout liquid to the washout station in the plate processor system. Some preferred embodiments have a storage tank with a capacity of equal to or greater than 150 litres. Some preferred embodiments have a storage tank with a capacity greater than 200 litres e.g. 220 litres.

The storage tank comprises an outlet for the outlet of filtered washout water to the washout station of the plate processor system. Preferably, a pipe or tubing is connected between the outlet and the washout station.

The filtration chamber preferably comprises a lid to prevent further contamination of the waste washout liquid e.g. by dust and other particulate matter which would increase clogging of the filter material.

The activation unit triggers movement of the perforated conveyor when the level of water within the filtration chamber reaches a predetermined height. The waste washout liquid received in the filtration chamber will contain polymer debris which is deposited onto the filter material supported on the perforated conveyor as the waste washout liquid moves through into the storage tank (either under gravitational pull or under the action of a pump as discussed above). The polymer debris clogs the filter material thus impeding and eventually preventing the passage of further waste washout liquid through the filter material. Once this occurs, the waste washout liquid becomes trapped within the filtration chamber and the level of waste washout liquid in the filtration chamber rises. Once the level of waste washout liquid in the filtration chamber rises above a predetermined level, the activation unit triggers the perforated conveyor to move the clogged filter material away from the base of the filtration chamber whilst providing fresh filter material to allow filtration of the waste washout liquid within the filtration chamber to continue without interruption.

The activation unit may also be used to detect the presence of filter material and to alert the user (e.g. via the plate processor control panel) if no filter material is present.

The activation unit preferably contains a float switch for detecting when the level of water within the filtration chamber rises above the predetermined level. The float will rise and cause the activation unit to trigger the perforated conveyor when the float rises about the predetermined height. The float may fall below a second predetermined level if no filter material is present in the filtration chamber and this will cause the activation unit to provide an alert to the user (e.g. via the plate processor control panel).

In preferred embodiments, the perforated conveyor comprises at least one and preferably a plurality of apertures e.g. holes or slots. More preferably, the perforated conveyor comprises a plurality of apertures spaced over the conveyor e.g. equally spaced over the conveyor. Most preferably, the perforated conveyor comprises a mesh or sieve e.g. a wire mesh, especially a stainless steel wire mesh. By providing multiple perforations/apertures, preferably equally spaced over the conveyor, it is possible to allow maximum flow of waste washout liquid through the perforated conveyor at the base of the filtration chamber and thus through the filter material.

Preferably, the perforated conveyor comprises engagement means e.g. hooks or barbs for releasably engaging the filter material. This helps ensure effective conveyance of filter material to and away from the base of the filtration chamber.

Preferably, the perforated conveyor is flanked by side walls which help channel any leakage of waste washout liquid into the storage tank.

In preferred embodiments, the filter unit further comprises a filter material holder for holding/storing filter material and/or dispensing filter material onto the perforated conveyor. For example, the filter material may be provided as a roll of filter material e.g. carried on a hollow tube formed, for example, of plastics material, metal or cardboard. In this case, the filter material holder may comprise one or more lugs, rods or bars for insertion into the hollow tube carrying the filter material. In this way, as the conveyor conveys used/clogged filter material away from the base of the filtration chamber, the roll of filter material can unroll (either by movement of the roll of filter material around the filter material holder or by synchronous movement of the filter material holder and the roll of filter material) to provide fresh, clean, unused filter material to the perforated conveyor at the base of the filtration chamber.

In preferred embodiments, the filter unit further comprises a used filter material bin for receiving used/clogged filter material from the perforated conveyor. As the perforated conveyor moves used filter material away from the base of the filtration chamber, the used filter material is released into the bin for subsequent disposal. This disposal need only be carried out periodically as the bin becomes full and the disposal can be carried out quickly and easily with minimal mess (especially if the bin is lined with a disposable bag/liner).

The filter unit of the first aspect of the present invention can be used with any suitable filter material but is preferably used with a textile filter material. The filter material preferably has a mesh size of between 5 to 300 micrometers and preferably between 30 to 200 micrometers. As discussed above, the filter material may be provided on a roll e.g. 50m or 100m of filter material or even more may be formed into a roll e.g. around a hollow tube. The filter material may have a width of 250mm to 1250mm.

In some embodiments (especially where the filter fabric used has a relatively large mesh size), the filter unit further comprises secondary filtration means to fine-filter the filtered washout liquid. This secondary filtration means may comprise one or more filter candles or cartridges e.g. a ceramic filter candle or cartridge. It may comprise a mesh e.g. a stainless steel or fabric mesh. Preferably, the secondary filtration means is adapted to remove particles having a particle size as small as 5 micrometers.

Preferably, the secondary filtration means is connected to the storage tank such that at least a portion (e.g. 30% of the storage tank volume or around 30 litres) of the filtered washout liquid can pass from the storage tank to the secondary filtration means and then fine-filtered washout liquid can pass back to the storage tank (after secondary filtration).

This continuous replacement of filtered washout liquid from the storage tank with fine-filtered washout liquid from the secondary filtration means ensures that any debris remaining in the filtered washout liquid is reduced. The secondary filtration typically takes longer (per unit volume) that the filtration through the filter material (e.g. secondary filtration of 30 litres typically takes around an hour). The faster filtration through the filter material provides a sufficient volume of filtered washout liquid in a relatively short space of time to enable prompt recycling to the washout station.

In preferred embodiments, at least part of the inside (and preferably the whole of the inside) of the storage tank is coated with a non-stick coating e.g. Teflon™. This ensures that any debris remaining in the filtered washout liquid remains suspended within the filtered washout liquid rather than sticking to the internal walls of the storage tank. In this way, the suspended debris is more likely to pass to the secondary filtration means where it can be trapped and removed by secondary filtration.

In a second aspect, the present invention provides a plate processor system having a washout station comprising a filter unit according to the first aspect. Preferably, the filter unit forms part of an in-line plate processor system.

In a third aspect, the present invention provides the use of a filter unit according to the first aspect in a plate processor system.

In a fourth aspect, the present invention provides a method of filtering waste washout liquid from a plate processor system, the method comprising:
supporting a filter material on a perforated conveyor at the base of a filtration chamber in a filter unit;
supplying waste washout liquid to the filtration chamber;
allowing waste washout liquid to pass through the filter material and perforated conveyor into a storage tank for storing filtered washout liquid;
detecting when waste washout liquid within the filtration chamber reaches a predetermined level; and
upon detecting the predetermined level of waste washout liquid in the filtration chamber, activating the perforated conveyor to convey filter material to and away from the base of the filtration chamber.

In preferred embodiments of the present invention, the method comprises allowing waste washout liquid to pass through the filter material and perforated conveyor into a storage tank under gravitational pull or under the force of a pump e.g. a vacuum pump.

Preferably, the method further comprises heating (e.g. to between 15 to 60°C) the filtered waste washout liquid in the storage tank using heating means prior to its recycling back to the washout station of the plate processor system. Preferably, the method comprises heating the filtered washout liquid using heating means comprising at least one heat pad and/or at least one heating element. The at least one heat pad may be a ceramic- or silicone-based heat pad. The at least one heat pad may be affixed to a wall of the storage tank e.g. to an outer wall of the storage tank. The at least one heating element may be an immersion heater for immersion into the filtered washout liquid within the storage tank. By heating the filtered washout liquid prior to its recycling back to the washout station of the plate processor, it is possible to carry out the washout step using heated washout liquid which significantly improves the effectiveness of the washout step.

In preferred embodiments, the method comprises dispensing softener and/or surfactant from a surfactant dispenser and/or a water-softener dispenser into the filtered washout liquid within the storage tank. The or each dispenser may include a pump e.g. a peristaltic pump to dispense a measured quantity of surfactant/softener into the filtered washout liquid at measured intervals. By providing a surfactant/softener dispenser to add surfactant/softener to the filtered washout liquid prior to its recycling back to the washout station of the plate processor, it is possible to carry out the washout step using soapy/softened washout liquid which significantly improves the effectiveness of the washout step. Furthermore, the softener/surfactant helps prevent the polymer debris from coagulating which helps reduce clogging of the filter material.

In preferred embodiments, the method further comprises prevent ingress of dust and other particulate matter into the waste washout liquid by providing a lid to the filtration chamber.

Preferably, the method comprises detecting when waste washout liquid within the filtration chamber reaches a predetermined level and activating the perforated conveyor, using an activation unit containing a float switch. The activation unit triggers movement of the perforated conveyor when the level of water within the filtration chamber reaches a predetermined height. The waste washout liquid received in the filtration chamber will contain polymer debris which is deposited onto the filter material supported on the perforated conveyor as the waste washout liquid moves through into the storage tank (either under gravitational pull or under the action of a pump as discussed above). The polymer debris clogs the filter material thus impeding and eventually preventing the passage of further waste washout liquid through the filter material. Once this occurs, the waste washout liquid becomes trapped within the filtration chamber and the level of waste washout liquid in the filtration chamber rises. Once the level of waste washout liquid in the filtration chamber rises above a predetermined level, the activation unit triggers the perforated conveyor to move the clogged filter material away from the base of the filtration chamber whilst providing fresh filter material to allow filtration of the waste washout liquid within the filtration chamber to continue uninterrupted.

Preferably, the method further comprises using an activation unit containing a float switch to detect the absence of filter material on the perforated conveyor.

In preferred embodiments, the method comprises supporting the filter material on a perforated conveyor comprising at least one and preferably a plurality of apertures e.g. holes or slots. More preferably, the method comprises supporting the filter material on a perforated conveyor comprising a plurality of apertures spaced over the conveyor e.g. equally spaced over the conveyor. Most preferably, the method comprises supporting the filter material on a perforated conveyor comprising a mesh or sieve e.g. a wire mesh, especially a stainless steel wire mesh. By providing multiple perforations/apertures, preferably equally spaced over the conveyor, it is possible to allow maximum flow of waste washout liquid through the perforated conveyor at the base of the filtration chamber and thus through the filter material.

Preferably, the method comprises supporting the filter material on a perforated conveyor comprising engagement means e.g. hooks or barbs for releasably engaging the filter material. This helps ensure effective conveyance of filter material to and away from the base of the filtration chamber.

In preferred embodiments, the method further comprises holding/storing the filter material in a filter material holder and/or dispensing filter material from the filter material holder onto the perforated conveyor. For example, the filter material may be provided as a roll of filter material e.g. carried on a hollow tube formed, for example, of plastics material, metal or cardboard. In this case, the filter material holder may comprise one or more lugs, rods or bars for insertion into the hollow tube carrying the filter material. In this way, as the conveyor conveys used/clogged filter material away from the base of the filtration chamber, the roll of filter material can unroll (either by movement of the roll of filter material around the filter material holder or by synchronous movement of the filter material holder and the roll of filter material) to provide fresh, clean, unused filter material to the perforated conveyor at the base of the filtration chamber.

In preferred embodiments, the method further comprises receiving used/clogged filter material from the perforated conveyor in a used filter material bin. As the perforated conveyor moves used filter material away from the base of the filtration chamber, the used filter material is released into the bin for subsequent disposal. This disposal need only be carried out periodically as the bin becomes full and the disposal can be carried out quickly and easily with minimal mess (especially if the bin is lined with a disposable bag/liner).

The method of the fourth aspect of the present invention can use any suitable filter material but is preferably used with a textile filter material. The filter material preferably has a mesh size of between 5 to 300 micrometers and preferably between 30 to 200 micrometers. As discussed above, the filter material may be provided on a roll e.g. 50m or 100m of filter material or even more may be formed into a roll e.g. around a hollow tube. The filter material may have a width of 250mm to 1250mm.

In some embodiments (especially where the filter fabric used has a relatively large mesh size), the method further comprises carrying out secondary filtration of the filtered washout liquid using secondary filtration means to fine-filter the filtered washout liquid. This secondary filtration means may comprise one or more filter candles or cartridges e.g. a ceramic filter candle or cartridge. It may comprise a mesh e.g. a stainless steel or fabric mesh. Preferably, the secondary filtration means is adapted to remove particles having a particle size as small as 5 micrometers.

Preferably, the method comprises passing at least a portion (e.g. 30% of the storage tank volume or around 30 litres) of the filtered washout liquid from the storage tank to the secondary filtration means and then subsequently passing the fine-filtered washout liquid back to the storage tank (after secondary filtration).

This continuous replacement of filtered washout liquid from the storage tank with fine-filtered washout liquid from the secondary filtration ensures that any debris remaining in the filtered washout liquid is reduced.

The plate for use with the invention may be a photopolymer relief printing or moulding plate, a pre-sensitised aluminium printing plate, or any other type of plate which needs to be washed out post-exposure to remove unexposed areas. The plate may be either water washable, in which case the washout liquid is water or a suitable aqueous solution, or organic solvent washable, in which case the washout liquid comprises one or more appropriate organic solvents. Preferably, the plate is water washable.

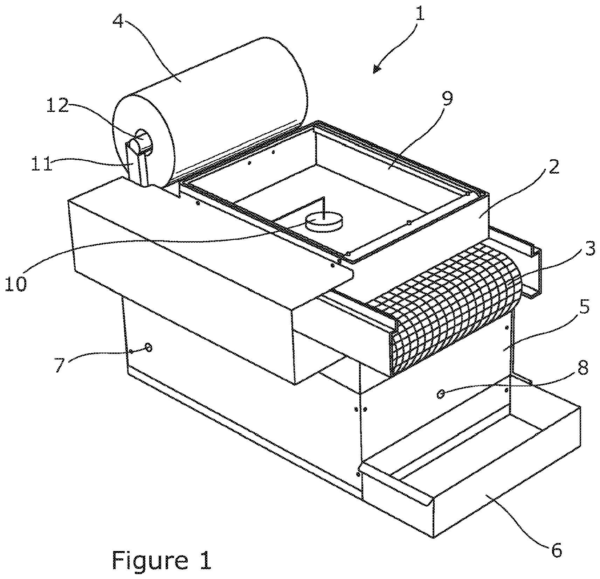

A preferred embodiment of the invention will now be illustrated by way of example, with reference to Figure 1.

### DETAILED DESCRIPTION OF A PREFERRED EMBODIMENT

Figure 1 shows a filter unit 1 for filtering waste washout liquid from a plate processor system (not shown).

The filter unit comprises a filtration chamber 2 for receiving waste washout liquid from the wash station. The filtration chamber includes a lid 9 for preventing dust and other particulate matter from settling in the waste washout liquid. The base of the filtration chamber 2 is defined by a perforated conveyor 3 which comprises a stainless steel wire mesh. The perforated conveyor 3 also includes a series of intermittent barbs (not shown).

The perforated conveyor 3 supports a textile filter material (not shown) having a mesh size of 50 micrometers. The filter material supported on the perforated conveyor forms a portion of a roll 4 of textile filter material having a length of 25m and a width of 250mm. The roll 4 is supported on a filter material holder which has two upstanding arms 11 supporting an elongated rod 12. The rod has a diameter which is smaller than the internal diameter of the roll 4 so that roll 4 is free to rotate on the rod.

The filtration chamber 2 is provided with an activation unit comprising a float switch 10 for detecting the level when the level of waste washout liquid within the filtration chamber 2 reaches a predetermined level.

The filtration chamber 2 is positioned directly above a storage tank 5 for storing filtered washout liquid after it has passed through the filter material on the perforated conveyor 3. The storage tank is formed stainless steel and has a capacity of 130 litres. Ceramic heating pads are provided on the outer walls of the storage tank 5 for heating filtered washout liquid within the storage tank 5. In alternative embodiments, an immersion heater may be provided in place of the heating pads.

When a plate is processed at a washout station in a plate processor system, polymer debris is generated which is carried in the waste washout liquid and received in the filtration chamber 2. Since the base of the filtration chamber 2 is defined by the perforated conveyor supporting a textile filter material, the waste washout liquid is able to filter, under gravitational pull, through the filter material/perforated conveyor 3 and into the storage tank 5 below. In alternative embodiments, the filtration chamber 2 is sealed and the waste washout liquid is drawn through the filter material/perforated conveyor by a pump e.g. a vacuum pump.

As the waste washout liquid is drawn through the filter material/perforated conveyor 3, polymer debris within the waste washout liquid is retained on the filter material.

After prolonged use, the filter material becomes clogged or blinded by the presence of the polymer debris. This slows the flow of waste washout liquid through the filter material/perforated conveyor and, ultimately prevents the passage of waste washout liquid through the filter material/perforated conveyor. Once waste washout liquid is prevented from passing into the storage tank 5, it is retained in the filtration chamber 2 and thus the level of waste washout liquid in the filtration chamber 2 rises.

Once the level of waste washout liquid within the filtration chamber 2 reaches a predetermined level, a float switch in the activation unit triggers movement of the perforated conveyor 3.

Once activated, the perforated conveyor 3 moves the clogged filter material away from the base of the filtration chamber 2 and into a used filter material bin 6. The intermittent barbs on the perforated conveyor 3 ensure a reliable grip on the filter material as the filter material is moved. Movement of the perforated conveyor 3 also draws fresh filter material from the roll 4 of filter material by rotation of the roll 4 about the elongated rod of the filter material holder. The fresh textile material moves to the base of the filtration chamber 2 so that filtration of the waste washout liquid can continue without interruption and without any action on the part of the user.

Used filter material is collected in the bin 6 which is lined with a bag. Once the bag is full, it can simply be sealed and the used filter material (along with the trapped polymer debris) can be easily and cleanly disposed of.

The storage tank 5 has an outlet 8 connected to a secondary filtration unit (not shown) which is a ceramic candle filtration system capable of removing debris down to 5 micrometers in size. Thirty litres of filtered waste washout liquid is transported from the storage tank 5 to the secondary filtration unit for fine filtration. Subsequently, this fine-filtered washout liquid is transferred back to the storage tank 5. The flow of filtered washout liquid to the secondary filtration unit and of fine-filtered washout liquid back to the storage tank 5 is continuous and helps reduce the amount of debris contained within the storage tank 5.

The inside of the storage tank 5 is coated with a non-stick coating e.g. Teflon™. This ensures that any debris remaining in the filtered washout liquid remains suspended within the filtered washout liquid and is carried to the secondary filtration unit rather than sticking to the internal walls of the storage tank 5.

Filtered washout liquid captured in the storage tank 5 is subjected to heating (to between 25 and 60°C) by the heating pads.

The filter unit 1 further comprises a surfactant dispenser and a water-softener dispenser (not shown) for dispensing surfactant/softener into the filtered washout liquid within the storage tank 5. Each dispenser includes a peristaltic pump to dispense a measured quantity of surfactant/softener into the filtered washout liquid at measured intervals. Accordingly, it is possible to carry out the washout step using warm/hot soapy/softened washout liquid which significantly improves the effectiveness of the washout step. Furthermore, the softener/surfactant helps prevent the polymer debris from coagulating which helps reduce clogging of the filter material. The surfactant/softener is not consumed or removed during the filtration with the filter unit 1 or the secondary filtration unit so the amount of softener/surfactant used can be minimised.

The storage tank 5 comprises an outlet 7 for the outlet of filtered washout water to the washout station of the plate processor system. A pipe or tubing is connected between the outlet 7 and the washout station.

It is to be understood that variants of the above described embodiment of the invention in its various aspects, such as would be readily apparent to the skilled person, may be made without departing from the scope of the invention in any of its aspects.

## Claims

1. A filter unit for filtering waste washout liquid from a plate processor system, said unit comprising:
a filtration chamber for receiving waste washout liquid,
a perforated conveyor for supporting a filter material at the base of the filtration chamber and for conveying filter material to and away from the base of the filtration chamber;
an activation unit for activating said conveyor when waste washout liquid reaches a predetermined height within said filtration chamber; and
a storage tank for storing filtered washout liquid after it has passed through said filter material and perforated base.

2. A filter unit according to claim 1 further comprising a pump for driving washout liquid through the filter material/perforated conveyor into the storage tank.

3. A filter unit according to any one of the preceding claims wherein the storage tank comprises heating means for heating the filtered washout liquid.

4. A filter unit according to any one of the preceding claims wherein the perforated conveyor comprises engagement means for releasably engaging the filter material.

5. A filter unit according to any one of the preceding claims further comprising secondary filtration means to fine-filter the filtered washout liquid.

6. A filter unit according to any one of the preceding claims wherein at least part of the inside of the storage tank is coated with a non-stick coating.

7. A plate processor system having a washout station comprising a filter unit according to any one of the preceding claims.

8. A method of filtering waste washout liquid from a plate processor system, the method comprising:
supporting a filter material on a perforated conveyor at the base of a filtration chamber in a filter unit;
supplying waste washout liquid to the filtration chamber;
allowing waste washout liquid to pass through the filter material and perforated conveyor into a storage tank for storing filtered washout liquid;
detecting when waste washout liquid within the filtration chamber reaches a predetermined level; and
upon detecting the predetermined level of waste washout liquid in the filtration chamber, activating the perforated conveyor to convey filter material to and away from the base of the filtration chamber.

9. Method according to claim 8 comprising allowing waste washout liquid to pass through the filter material and perforated conveyor into a storage tank under gravitational pull or under the force of a pump.

10. Method according to claim 8 or 9 further comprising heating the filtered waste washout liquid in the storage tank using heating means.

11. Method according to any one of claims 8 to 10 comprising dispensing softener and/or surfactant from a surfactant dispenser and/or a water-softener dispenser into the filtered washout liquid within the storage tank.

12. Method according to any one of claims 8 to 11 comprising detecting when waste washout liquid within the filtration chamber reaches a predetermined level; and activating the perforated conveyor, using an activation unit.

13. Method according to any one of claims 8 to 12 comprising supporting the filter material on a perforated conveyor comprising engagement means for releasably engaging the filter material.

14. Method according to any one of claims 8 to 13 comprising carrying out secondary filtration of the filtered washout liquid using secondary filtration means to fine-filter the filtered washout liquid.

15. Method according to claim 14 comprising passing at least a portion of the filtered washout liquid from the storage tank to the secondary filtration means and then subsequently passing the fine-filtered washout liquid back to the storage tank.

## Patentansprüche

1. Filtereinheit zum Filtern von Abfallausspülflüssigkeit aus einem Plattenverarbeitungssystem, wobei die Einheit Folgendes umfasst:
eine Filterkammer zum Aufnehmen von Abfallausspülflüssigkeit,
ein perforiertes Förderband zur Auflage eines Filtermaterials an der Basis der Filterkammer und zum Fördern von Filtermaterial zur Basis der Filterkammer hin und von dieser weg;
eine Aktivierungseinheit zum Aktivieren des Förderbands, wenn Abfallausspülflüssigkeit eine vordefinierte Höhe in der Filterkammer erreicht; und
einen Speichertank zum Speichern von gefilterter Ausspülflüssigkeit nach dem Hindurchtreten derselben durch das Filtermaterial und die perforierte Basis.

2. Filtereinheit nach Anspruch 1, ferner umfassend eine Pumpe zum Treiben der Ausspülflüssigkeit durch das Filtermaterial/das perforierte Förderband in den Speichertank.

3. Filtereinheit nach einem der vorhergehenden Ansprüche, wobei der Speichertank ein Heizmittel zum Erhitzen der gefilterten Ausspülflüssigkeit umfasst.

4. Filtereinheit nach einem der vorhergehenden Ansprüche, wobei das perforierte Förderband ein Eingriffsmittel zum lösbaren Eingreifen in das Filtermaterial umfasst.

5. Filtereinheit nach einem der vorhergehenden Ansprüche, ferner umfassend ein sekundäres Filtermittel zum Feinfiltern der gefilterten Ausspülflüssigkeit.

6. Filtereinheit nach einem der vorhergehenden Ansprüche, wobei mindestens ein Teil des Inneren des Speichertanks mit einer Antihaftbeschichtung beschichtet ist.

7. Plattenverarbeitungssystem mit einer Ausspülstation, umfassend eine Filtereinheit gemäß einem der vorhergehenden Ansprüche.

8. Verfahren zum Filtern von Abfallausspülflüssigkeit von einem Plattenverarbeitungssystem, wobei das Verfahren Folgendes umfasst:
Aufliegenlassen eines Filtermaterials auf einem perforierten Förderband an der Basis einer Filterkammer in einer Filtereinheit;
Bereitstellen von Abfallausspülflüssigkeit für die Filterkammer;
Hindurchtretenlassen von Abfallausspülflüssigkeit durch das Filtermaterial und das perforierte Förderband in einen Speichertank zum Speichern von gefilterter Ausspülflüssigkeit;
Detektieren, wann Abfallausspülflüssigkeit in der Filterkammer einen vordefinierten Pegel erreicht; und
Infolge des Detektierens des vordefinierten Pegels der Abfallausspülflüssigkeit in der Filterkammer, Aktivieren des perforierten Förderbands zum Fördern von Filtermaterial hin zur Basis der Filterkammer und von dieser weg.

9. Verfahren nach Anspruch 8, umfassend das Hindurchtretenlassen von Abfallausspülflüssigkeit durch das Filtermaterial und das perforierte Förderband in einen Speichertank unter Einwirkung der Schwerkraft oder einer Pumpe.

10. Verfahren nach Anspruch 8 oder 9, ferner umfassend das Erhitzen der gefilterten Abfallausspülflüssigkeit im Speichertank unter Verwendung eines Heizmittels.

11. Verfahren nach einem der Ansprüche 8 bis 10, umfassend das Abgeben eines Enthärters und/oder eines Tensids durch einen Tensidspender und/oder einen Wasserenthärter-Spender in die gefilterte Ausspülflüssigkeit im Speichertank.

12. Verfahren nach einem der Ansprüche 8 bis 11, umfassend das Detektieren, wann Abfallausspülflüssigkeit in der Filterkammer einen vordefinierten Pegel erreicht; und Aktivieren des perforierten Förderbands unter Verwendung einer Aktivierungseinheit.

13. Verfahren nach einem der Ansprüche 8 bis 12, umfassend das Aufliegenlassen des Filtermaterials auf einem perforierten Förderband, umfassend Eingriffsmittel zum lösbaren Eingreifen in das Filtermaterial.

14. Verfahren nach einem der Ansprüche 8 bis 13, umfassend das Ausführen einer sekundären Filterung der gefilterten Ausspülflüssigkeit unter Verwendung eines sekundären Filtermittels zum Feinfiltern der gefilterten Ausspülflüssigkeit.

15. Verfahren nach Anspruch 14, umfassend das Hindurchtreten von mindestens einem Abschnitt der gefilterten Ausspülflüssigkeit aus dem Speichertank zum sekundären Filtermittel und das anschließende Hindurchtreten der feingefilterten Ausspülflüssigkeit zurück zum Speichertank.

## Revendications

1. Unité de filtre pour filtrer un liquide de lavage de déchets d'un système de processeur à plaques, ladite unité comprenant :
une chambre de filtration pour recevoir un liquide de lavage de déchets,
un transporteur perforé pour supporter un matériau de filtre au niveau de la base de la chambre de filtration et pour transporter un matériau de filtre vers la base de la chambre de filtration et à l'opposé de celle-ci ;
une unité d'activation pour activer ledit transporteur lorsqu'un liquide de lavage de déchets atteint une hauteur prédéterminée à l'intérieur de ladite chambre de filtration ; et
un réservoir de stockage pour stocker un liquide de lavage filtré après qu'il soit passé à travers ledit matériau de filtre et ladite base perforée.

2. Unité de filtre selon la revendication 1, comportant en outre une pompe pour conduire du liquide de lavage à travers le matériau de filtre/le transporteur perforé jusque dans le réservoir de stockage.

3. Unité de filtre selon l'une quelconque des revendications précédentes, dans laquelle le réservoir de stockage comporte des moyens de chauffage pour chauffer le liquide de lavage filtré.

4. Unité de filtre selon l'une quelconque des revendications précédentes, dans laquelle le transporteur perforé comprend des moyens de mise en prise, pour mise en prise de manière libérable du matériau de filtre.

5. Unité de filtre selon l'une quelconque des revendications précédentes, comportant en outre des moyens de filtrage secondaire pour filtrer finement le liquide de lavage filtré.

6. Unité de filtre selon l'une quelconque des revendications précédentes, dans laquelle au moins une partie de l'intérieur du réservoir de stockage est revêtue d'un revêtement non-collant.

7. Système de processeur à plaques ayant une station de lavage comprenant une unité de filtre selon l'une quelconque des revendications précédentes.

8. Procédé de filtrage de liquide de lavage de déchets à partir d'un système de processeur à plaques, le procédé comprenant les étapes consistant à :
supporter un matériau de filtre sur un transporteur perforé à la base d'une chambre de filtration dans une unité de filtre ;
fournir du liquide de lavage de déchets à la chambre de filtration ;
permettre au liquide de lavage de déchets de passer à travers le matériau de filtre et le transporteur perforé jusque dans un réservoir de stockage pour stocker du liquide de lavage filtré ;
détecter quand le liquide de lavage de déchets dans la chambre de filtration atteint un niveau prédéterminé ; et
lors de la détection du niveau prédéterminé de liquide de lavage de déchets dans la chambre de filtration, activer le transporteur perforé pour transporter le matériau de filtre vers et loin de la base de la chambre de filtration.

9. Procédé selon la revendication 8, comprenant l'étape consistant à laisser le liquide de lavage de déchets passer à travers le matériau de filtre et le transporteur perforé jusque dans un réservoir de stockage sous l'action de la gravité ou sous la force d'une pompe.

10. Procédé selon la revendication 8 ou 9, comportant en outre le chauffage du liquide de lavage de déchets filtré dans le réservoir de stockage en utilisant des moyens de chauffage.

11. Procédé selon l'une quelconque de revendications 8 à 10, comprenant la distribution d'un émollient et/ou d'un tensioactif depuis un distributeur de tensioactif et/ou un distributeur d'émollient-eau dans le liquide de lavage filtré dans le réservoir de stockage.

12. Procédé selon l'une quelconque des revendications 8 à 11, comprenant la détection du moment où le liquide de lavage de déchets dans la chambre de filtration atteint un niveau prédéterminé ; et l'activation du transporteur perforé en utilisant une unité d'activation.

13. Procédé selon l'une quelconque de revendications 8 à 12, comprenant le support du matériau de filtre sur un transporteur perforé comprenant des moyens de mise en prise pour une mise en prise de manière libérable du matériau de filtre.

14. Procédé selon l'une quelconque de revendications 8 à 13, comprenant la mise en oeuvre d'une filtration secondaire du liquide de lavage filtré en utilisant des moyens de filtration secondaire pour filtrer finement le liquide de lavage filtré.

15. Procédé selon la revendication 14, comprenant l'étape consistant à faire passer au moins une partie du liquide de lavage filtré depuis le réservoir de stockage vers les moyens de filtration secondaire, et à faire passer ensuite le liquide de lavage finement filtré en arrière vers le réservoir de stockage.
